# EUROPEAN PATENT APPLICATION

(11) **EP 4 819 773 A1**
(43) Date of publication of application: **07.10.2026**
(21) Application number: 25167561.7
(22) Date of filing: 31.03.2025
(51) Int. Cl.: H05K 3/00, H05K 1/03, H05K 3/42

(54) **COMPONENT CARRIER WITH EMBEDDED OPENINGS**

(71) Applicant: AT & S Austria Technologie & Systemtechnik Aktiengesellschaft, 8700 Leoben-Hinterberg (AT)
(72) Inventor: GRAMUELLER, Michael, 8700 Leoben (AT); ZUENDEL, Julia, 8700 Leoben (AT); TRISCHLER, Heinrich, 8063 Eggersdorf (AT)
(74) Representative: Dilg, Haeusler, Schindelmann Patentanwaltsgesellschaft mbH

(57) **Abstract**

The present invention describes a component carrier (100) comprising a stack with a plurality of electrically insulating layer structures, wherein a first one (101) of the plurality of electrically insulating layer structures comprising a through hole (104) passing from a first main surface (105) to an opposed second main surface (106) of the first electrically insulating layer structure (101). A second one (102) of the plurality of electrically insulating layer structures comprises fillers (111) embedded therein, wherein the second electrically insulating layer structure (102) comprises a third main surface (107) in contact with the first main surface (105) of the first electrically insulating layer structure (101), closing the through hole (104), and comprises a fourth main surface (108) opposed to the third main surface (107). The second electrically insulating layer structure (102) comprises a cover portion (109) and a surrounding portion (110), wherein the cover portion (109) overlaps the through hole (104). The fillers (111) in the surrounding portion (110) are closer to the fourth main surface (108) than the fillers (111) in the cover portion (109).

## Description

### Field of the Invention

The invention relates to a component carrier comprising embedded and covered openings and a method of manufacturing a component carrier.

### Technological Background

In the context of growing product functionalities of component carriers equipped with one or more components and increasing miniaturization of such components as well as a rising number of components to be connected to the component carriers such as printed circuit boards, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

In particular, a component carrier comprises a plurality of through holes being partially filled with electrically conductive material for providing an electrical connection. However, the manufacturing of those partially filled through holes might be a challenge, because the filling depth of the electrically conductive material is difficult to adjust in conventional manufacturing methods.

### Summary of the Invention

There may be a need to provide a through hole in a component carrier in a failure robust way and in a high precision.

According to an exemplary embodiment of the invention, a component carrier comprising a stack with a plurality of electrically insulating layer structures is described. A first one of the plurality of electrically insulating layer structures comprises a through hole passing from a first main surface to an opposed second main surface of the first electrically insulating layer structure. A second one of the plurality of electrically insulating layer structures comprises fillers embedded therein, wherein the second electrically insulating layer structure comprises a third main surface in contact with the first main surface of the first electrically insulating layer structure, closing the through hole, and comprises a fourth main surface opposed to the third main surface. The second electrically insulating layer structure comprises a cover portion and a surrounding portion, wherein the cover portion overlaps the through hole. The fillers in the surrounding portion are closer to the fourth main surface than the fillers in the cover portion.

According to another exemplary embodiment of the invention, a method of manufacturing a component carrier is provided, wherein a stack comprising a plurality of electrically insulating layer structures is provided and a through hole is formed in a first one of the plurality of electrically insulating layer structures. The through hole passes from a first main surface to a second opposed main surface of the first layer electrically insulating layer structure, wherein a second one of the plurality of electrically insulating layer structures comprises fillers embedded therein. The second electrically insulating layer structure comprises a third main surface in contact with the first main surface of the first electrically insulating layer structure, closing the through hole, and comprises a fourth main surface opposed to the third main surface. The second electrically insulating layer structure comprises a cover portion and a surrounding portion, wherein the cover portion overlaps the through hole. The fillers in the surrounding portion are closer to the fourth main surface than the fillers in the cover portion.

The term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. In particular, a component carrier may also be embodied as a flexible or semi-rigid substrate. A component carrier may also be a hybrid board combining different ones of the above-mentioned types of component carriers.

In the context of the present application, the term "stack" may particularly denote an arrangement of multiple planar layer structures which are mounted in parallel on top of one another. For example, the stack may be a laminated stack, i.e. comprising a plurality of layer structures connected by the application of heat and/or pressure.

In the context of the present application, the term "layer structure" may particularly denote a continuous layer, a patterned layer or a plurality of nonconsecutive islands within a common plane. The layer structures are arranged above each other along a stacking direction (z-direction for forming the stack).

The first electrically insulating layer structure consists of one or a plurality of layers comprising for example resin without fibers or comprising for example fillers, such as fibers, which are woven or which comprises a uniform direction.

The first electrically insulating layer structure comprises respective through holes between the first main surface and the opposed second main surface of the first electrically insulating layer structure.

In the context of the present application, the term "main surface" of a body (such as the stack or a respective first or second electrically insulating layer structure) may particularly denote one of two largest opposing surfaces of the body (such as the stack or a respective first or second electrically insulating layer structure). The thickness of a body (such as the stack or a respective first or second layer structure), may be defined by the vertical distance (along the stack direction, defining the direction along the layers attached above each other) between the two opposing main surfaces.

The first main surface of the first electrically insulating layer structure defines the surface, onto which the second electrically insulating layer directly abuts and is fixed to the second electrically insulating layer e.g. by curing. The second main surface of the first electrically insulating layer structure defines the main surface being opposed to the first main surface. The respective through hole extends between the first main surface and the second main surface through the first electrically insulating layer structure.

The third main surface of the second electrically insulating layer structure defines the surface, which is directly attached to the first main surface of the first electrically insulating layer structure. Specifically, the third main surface abuts onto the first main surface and is fixed to the first main surface e.g. by curing. The fourth main surface of the second electrically insulating layer structure is the main surface opposed to the third main surface and faces away from the first electrically insulating layer structure.

According to an exemplary embodiment, a component carrier (such as a printed circuit board or an integrated circuit substrate) comprises a (preferably laminated) layer stack having one or more through holes. The latter may be formed so as to extend through the stack and in particular through the first electrically insulating layer structure substantially perpendicular to the main surfaces of the first electrically insulating layer structure. Moreover, formation of the through hole(s) may be executed (for instance by laser drilling with appropriate laser operation parameters) in such a way that lateral walls of the first electrically insulating layer structure limit the through hole. Furthermore, an electrically insulating coating may be formed so that the latter coats the opposing main surfaces of the stack only partially and the sidewalls of the stack partially or entirely. Advantageously, a through hole with sidewalls has turned out as a proper basis for depositing an electrically insulating coating thereon, in particular in terms of homogeneity-related properties of the coating.

The second electrically insulating layer structure may be made of resin comprising the fillers. The fillers may provide a reinforcing function to the second electrically insulating layer structure.

According to an exemplary embodiment the second electrically insulating layer structure may have varied local concentration of fillers. Due to the varying concentration of the fillers in the second electrically insulating layer structure, a first area/portion (for example the cover portion) having a higher concentration of fillers and a second area/portion (for example the surrounding portion) having a lower concentration of fillers relative to each other may be created. The respective area (the first area of the second electrically insulating layer structure) comprising the higher concentration of fillers relative to the respective second area of the second electrically insulating layer structure shows more strength and hardness for example due to the higher curing state.

Hence, the distribution of the concentration of fillers in the respective areas (for example of the second electrically insulting layer structure) leads to varying curing state of the respective areas.

According to an exemplary embodiment, the fillers comprise fibers, in particular inorganic fibers. In a specific example, the fibers are glass fibers. In a further exemplary embodiment, the fibers are woven.

Specifically, the fibers are embedded e.g. in a moldable matrix, such as resin, and form a respective prepreg layer structure. Additionally or alternatively, the fillers may comprise particles having a round shape, for example spheres and/or ellipsoids. The fillers may comprise inorganic material, for example glass and/or metal salts, in particular calcium oxide, magnesium oxide and/or barium sulfate. The fillers may have an extension in one direction in the range from 20 nm to 10 µm. In the case of fibers, the fibers may have an extension in one direction in the range of 0.5 µm to 10 µm, in particular 3 µm. The term "one direction" may be interpreted as the direction perpendicular to a cross-sectional plane of a respective fibre and hence a lateral direction of a center/symmetry axis of a fiber. The one direction may define the length extension of a respective fiber.

The second electrically insulating layer structure comprises the cover portion and the surrounding portion. When viewing in normal direction on a plane of the first main surface, the cover portion is the portion covering the opening of the through holes in the first main surface. The surrounding portion surrounds the respective cover portion and edge sections of the through hole at the first main surface. Specifically, along the plane of the first main surface, the cover portion comprises at least an extension and size, respectively, of an extension and opening size (e.g. diameter, length and/or width) of the through hole at the first main surface. In an exemplary embodiment, the cover portion is larger than the through hole along the plane of the first main surface and hence overlaps over the edges of the through hole at the first main surface. In this regard, the surface area of the cover portion along the plane of the first main surface may be up to 20% larger than the opening area of the through hole at the first main surface. Hence, by providing the cover portion at least with the same size or larger than the opening area of the through hole at the first main surface it can be assured that the cover portion covers the through hole completely and the risk that resin flows from the surrounding portion into the through hole during lamination is reduced.The fillers of the surrounding portion are closer to the fourth main surface and the fillers of the cover portion are closer to the first main surface of the first electrically insulating layer structure and optionally partially in the through hole. This means that in the cover portion, the concentration of the fillers is higher closer to the first main surface and in the through hole, respectively, than the concentration of the fillers in the cover portion closer to the fourth main surface. In the cover portion, there may be also fillers located close to the fourth main surface, however, the majority of fillers, e.g. the higher concentration of fillers, is located closer to the third main surface and the first main surface, respectively. For example, when separating the cover portion and the surrounding portion of the second electrically insulating layer structure by a central dividing plane being parallel to the first main surface in a first (lower) volume part of the second electrically insulating layer structure being closer to the third main surface and a second volume part of the second (upper) electrically insulating layer structure being closer to the fourth main surface, in the first volume part of the cover portion, the concentration of fillers is higher than the concentration of fillers in the second volume part. In other words, the central dividing plane divides the second electrically insulating layer structure along the half thickness between the third and fourth main surface. Accordingly, in the surrounding portion, in the first volume part, the concentration of fillers is lower than the concentration of fillers in the second volume part.

Hence, the fillers of the cover portion are specifically more concentrated in the region of the through hole, so that due to the more concentrated fillers (i.e. higher number of fillers), the cover portion is harder and has a higher viscosity in the first volume part close to or in the through hole so that the flow of the material (resin) of the cover portion into that through hole is reduced and more controllable. Hence, by adjusting the concentration of the fillers in the cover portion and the surrounding portion of the same second electrically insulating layer structure, a respective control of the resin flow within the through hole during a lamination step is achieved.

Specifically, the respective control of the resin flow in direction to the through hole and specifically inside the through hole can be achieved by providing the second electrically insulating layer structure, comprising a first curing state (for example a higher viscosity, higher cross-linking state, more hardened, etc.) in the cover portion and a second curing state in the surrounding portion. This may be achieved by providing a selective curing of the respective portions, for example by covering the respective portion, which should have a lower viscosity (for example the surrounding portion) and treating the portion, for example the cover portion, which should have a higher viscosity, with temperature, ultraviolet or infrared (IR) radiation. For example, the surrounding portions surrounding the through hole may be covered during partial curing of the second electrically insulating structure so that the cover portion covering the through hole comprises a higher curing rate than the surrounding portions. Preferably, (after the manipulation of the second electrically insulating layer structure) the cover portion may have a lower flowability and/or higher viscosity than the surrounding portion. Hence, a precise control of the resin flow in defined areas during lamination is possible.

The spatial deviation of the concentration of the fillers in the surrounding portion and the concentration of the fillers in the cover portion may be attributed to the following reason: To achieve a reliable adhesion between the first of the plurality of electrically insulating layer structures and the second of the plurality of electrically insulating layer structures, the first electrically insulating layer structure having the through hole and the second electrically insulating layer structure comprising the fillers may be laminated together by application of elevated pressure, for example larger than 1.5 bar. Prior to lamination, a selective curing treatment is performed on the second electrically insulating layer structure, leading to the formation of cover portion and surrounding portion with the cover portion having a higher degree of curing relative to the curing degree of the surrounding portion such that the cover portion of the second electrically insulating layer structure shows a lower flowability into the through hole. Since the cover portion has the same size or overlaps the opening of the through hole at the first main surface, uncontrolled flow of flowable resin from the surrounding portion is prevented. Due to the application of pressure, the cover portion may be at least partially transferred into the through hole, which is covered by the cover portion. Furthermore, since the cover portion is more cured and thus comprises a higher viscosity than the surrounding portion, the reduction of the width of the second electrically insulating layer structure is reduced in comparison to an uncured or less cured portion, such as the surrounding portion. For example, in a lamination process, a prepreg used for the second electrically insulating layer structure may have initially a width of 80 µm (Micrometer) and is reduced to a width of 50 µm due to resin outflow from the surrounding portion to the environment and/or a flow of material of the cover portion into the through hole. The latter effect may be increased if a lot of through holes are present in the first electrically insulating layer structure. Hence, if the cover portion is precured before laminating the first and second insulating electrically layer structure together, the flow of resin of the cover portion into the through hole is reduced and hence the thickness loss of the second electrically insulating layer structure during lamination is reduced.

Also, due to the application of pressure during lamination, there is movement of the resin and the fillers of the second electrically insulating layer structure (for example resulting in squeezing out of resin from the surrounding portion) thereby finally resulting in the accumulation of fillers of the surrounding portion closer to the fourth main surface. The aforementioned action may happen simultaneously during the lamination process with the result of the lamination process, that the cover portion overlapping the through hole may have fillers farther away from the fourth main surface than the fillers of the surrounding portion.

### Detailed Description of Exemplary Embodiments

In the following, further exemplary embodiments of the component carrier and the method will be explained.

According to a further exemplary embodiment, the through hole is configured to be penetrated by a functional element. The functional element is defined as a mechanical part that is fixed into the through hole and abuts the inner wall surface of the through hole. Therefore, for example a sliding contact, for example an electrically conductive contact or a non-electrically conductive contact, may be formed. The functional element may be for example any component (including an electrical connector) with terminals/electrodes that can be inserted in the through hole. By defining more exact the concentration and arrangement of the fillers in the cover portion, the hardness of the cover portion due to the defined concentration of fillers closer to the third and first main surface, respectively, the section of the cover portion facing the through hole is more robust against an abutment of the functional element.

According to a further exemplary embodiment, a lateral wall of the through hole is covered by an electrically conductive structure. The lateral wall may also be covered by an electrically insulating structure. The lateral wall may be plated by a respective electrically conductive structure, such as copper. Hence, functional elements, for example of a component contact or probe electrode can be fixed in the through hole. The electrically conductive structure may also be a solid material that fills partially or completely the inner volume of the through hole.

In a first example for providing the electrically conductive structure in the through hole, first, the through holes are formed in the first electrically insulating layer structure. Next, before attaching the second electrically insulating layer structure, the electrically conductive structure is formed in the through by plating or filling. Subsequently, the second electrically insulating layer structure is attached to the first electrically insulating layer structure and both structures are bonded together by a lamination step.

In a second example for providing the electrically conductive structure, first, the through holes are formed in the first electrically insulating layer structure. Next, the second electrically insulating layer structure is attached to the first electrically insulating layer structure and both structures are bonded together by a lamination step. Since the second electrically insulating layer covers already the through at the first main surface, the electrically conductive structure is plated or filled from the second main surface (bottom side) of the first electrically insulating layer structure. The electrically conductive structure provides an electrical connection. Specifically, if only the lateral walls of the through hole are plated with the electrically conductive structure, the through hole forms a connection hole for contacts (e.g. contact pins) of components to be attached to the second main surface of the first electrically insulating layer structure. Furthermore, the electrically conductive structure may also be selected to provide a thermal conductive function. This may bring the advantage of electrically and/or thermally connecting the first main surface by the second main surface.

Hence, the functional element inserted into the through hole and being in contact with the lateral sidewall may be used to provide an electrical contact and/or to guide thermal energy away from the first electrically insulating layer structure and component carrier, respectively. The conductive structure plated on the lateral walls of the through hole facilitates also dissipation of heat, in addition to the electrical connection of the component.

Hence, by defining a higher concentration of fillers in the cover portion close to the through hole, the insertion depth of the functional element in the through hole may be amended.

According to a further exemplary embodiment, the material of the cover portion of the second electrically insulating layer structure partially fills the through hole. By defining more exact the amount of the cover portion flowing during lamination into the through hole and by the higher concentration of fillers in the cover portion closed to the first main surface and for example partially within the through hole, respectively, the insertion depth of the functional element in the through hole, for example inserted from the second main surface into the through hole, may be exactly defined and also due to the hardness of the cover portion in the region close to the first main surface and in the through hole, a more robust abutment of the functional element may be provided. Furthermore, if the insertion holes are filled from the second main surface by a functional material, for example by an electrically conductive material, such as copper, the volume and hence the insertion depth from the second main surface of the functional material within the through hole may be defined more exactly.

According to a further exemplary embodiment, the material of the cover portion in the through hole defines an internal boundary line between the electrically conductive structure and the material of the cover portion. Specifically, if the electrically conductive structure is a solid material that fills the inner volume along a complete cross-section of the through hole, the internal boundary line defines the interface plane between the interface of the electrically conductive structure within the through hole and the cover portion. The internal (interface) boundary line may define also the insertion depth of a component into the through hole to ensure contact with the electrically conductive structure, thereby ensure proper electrical connection with the electrical component and/or heat dissipation from the electrical component.

According to a further exemplary embodiment, the internal boundary line has an irregular shape. Specifically, due to the lateral wall of the through holes having a specific roughness, the flow of the material of the cover portion and/or the flow of the material of the electrically conductive structure into the through hole may differ between the region close to the lateral wall and a center section of the boundary line and the center of the through hole, respectively. Hence, due to the irregular shape of the boundary line between the cover portion and for example the electrically conductive material, and engagement of both materials is provided so that the risk of separation of both materials may be reduced.

According to a further exemplary embodiment, the material of the cover portion protrudes at the lateral walls of the through hole and/or the respective electrical conductive structure to form a side portion that protrudes more into the through hole than a central portion of the cover portion protruding in a central section of the through hole. Hence, when viewing from the second main surface to the first main surface in the through hole, the center section forms a dimple. Such dimple may be used for inspection from external side, since can be recognized easily.

According to a further exemplary embodiment at the central portion of the cover portion, a central protrusion (in a direction into the through hole) of material of the cover portion is formed, protruding (specifically protruding in a direction from the first main surface to the second main surface more into the through hole) more than other portions surrounding the protrusion of the central portion. Hence, a proper engagement between the electrically conductive structure and the material of the cover portion may be provided. Additionally or alternatively, the functional element may mechanically interact with the central portion and thus may ensure a proper alignment of the functional element, since it is centrally located (in regard to the radial extension of the through hole) in the through hole.

According to a further exemplary embodiment, the material of the cover portion of the second electrically insulating layer structure is penetrating in the through hole with a depth less than four times the thickness of the second electrically insulating layer structure. Hence, in other words, the main part of the through hole is filled with the electrically conductive structure and the material of the cover portion within the through hole forms a kind of seat for the electrically conductive structure within the through hole. For example, the cover portion of the second electrically insulating layer structure extends into the through hole from the first main surface to a specific filling height (depth). In an example, the filling height corresponds to less than 2% (in particular less than 5%, 10%, 20%, 30%, or 40%) of the through hole volume. Thus, a specific filling height, depending on the desired application, may be efficiently achieved by the cover portion.

According to a further exemplary embodiment, the first electrically insulating layer structure comprises further fillers. In an example, the further fillers may comprise the same material as the fillers. In another example, the material of the further fillers may be different than the material of the fillers. The further fillers form a roughened lateral wall of the through hole. Since a material removal process, for example mechanical drilling process and/or laser drilling process, is performed, the resin material of the first electrically insulating layer structure is easier to remove compared to the further fillers' material and thus the further fillers may at least partially protrude into the lateral wall of the through hole and thereby creating the roughened lateral wall. The material of the cover portion of the second electrically insulating layer structure is coupled to the roughened lateral wall of the through hole. A roughened lateral wall may have a better mechanical interaction to the material of the second electrically insulating layer structure, in particular the cover portion in comparison to a non-roughened lateral wall. The further fillers may consist of reinforcing fibers, such as reinforcing cloth, glass fibers or carbon fibers.

The first electrically insulating layer structure may be formed of resin including the further fillers, such as fibers and in particular woven fibers. The respective first electrically insulating layer structure comprises a plurality of layers each having respective fillers being arranged one above another along the stacking direction. Hence, when cutting the through holes, in particular by laser drilling or by mechanical drilling, cut fiber residues are formed along lateral walls of the through hole. Hence, by the fillers and the cut fibers, respectively, the roughened lateral wall of the through hole is formed. Thus, a stronger engagement and bonding between the lateral walls and the cover portion can be provided. The resin of the first electrically insulating layer structure may adhere to and/or intermingle with the resin of the second electrically insulating layer structure and thus may reduce the risk of delamination between the aforementioned layer structures.

According to a further exemplary embodiment, the stack comprises at least one further electrically conductive structure, wherein the at least one further electrically conductive structure comprises an edge portion provided around the through hole on the first main surface and sandwiched between the first electrically insulating layer structure and the second electrically insulating layer structure. The further electrically conductive structure may be made of electrically conductive material, such as copper. The further electrically conductive structure may not fully fill the through hole but comprises the edge section that covers for example a part of the first main surface and a region that surrounds the through hole. In a further exemplary embodiment, the further electrically conductive structure further comprises an internal section that extends within the through hole and covers fully or partially the lateral wall of the through hole. Additionally or alternatively, the further electrically conductive layer structure may be located between the first electrically insulating layer structure and the second electrically insulating layer structure. This may bring the advantage of routing electrically conductive traces between the first electrically conductive layer structure and the second electrically conductive layer structure, preferably additionally through the through hole.

Hence, the edge portion may form a conductive bridge between the first main surface and the above-mentioned electrically conductive structure filled within the through hole. Furthermore, the edge portion surrounding the through hole reinforces the corner and the edge, respectively of the first main surface surrounding the through hole. Furthermore, since the edge portion of the further electrically conductive structure is attached onto the first main surface, a step along the first main surface is formed so that the flow characteristics of the second electrically insulating layer structure during lamination can be affected.

According to a further exemplary embodiment, the second electrically insulating layer structure comprises an intermediate portion arranged between the cover portion and the surrounding portion. The intermediate portion overlaps the edge portion, wherein the fillers in the intermediate portion are closer to the fourth main surface than the fillers in the cover and/or the surrounding portion.

In other words, in the intermediate portion, the edge portion is arranged between the first main surface of the first electrically insulating layer structure and the second electrically insulating layer structure. Furthermore, the intermediate portion is arranged between the cover portion and the surrounding portion. Hence, as described above, the edge portion forms a step onto the first main surface and thereby affects the flowing characteristics of the second electrically insulating layer structure for example during lamination. Hence, thereby the fillers in the intermediate portion are closer to the fourth main surface than the fillers in the cover and/or the surrounding portion. As a result, in the intermediate portion, the part of the second electrically insulating layer structure being closer to the fourth main surface is more robust than the part of the second electrically insulating layer structure being closer to the fourth main surface in the surrounding portion and/or the cover portion.

According to a further exemplary embodiment, the second electrically insulating layer structure is formed such that the fourth main surface comprises a protrusion, in particular a bump, at the intermediate portion. Hence, since the edge portion of the further electrically conductive structure is arranged in the intermediate section between the second electrically insulating layer structure and the first electrically insulating layer structure, the above-mentioned protrusion may be formed. Hence, along the surface of the fourth main surface, the location of the covered through holes may be easier detectable, since the protrusion may be visualized.

According to a further exemplary embodiment the fillers in the second electrically insulating layer structure are embedded in a matrix material, in particular resin, wherein the ratio of fillers/matrix material in the intermediate portion is higher than the ratio of fillers/matrix material in the cover portion and the surrounding portion. Hence, since the edge portion forms a step onto the first main surface and thereby affects the flowing characteristics of the second electrically insulating layer structure for example during lamination, as a result, the overall ratio and hence concentration of the fillers in the matrix material is increased so that not only the section closest to the fourth main surface of the second electrically insulating layer structure but also the complete section of the second electrically insulating layer structure in the intermediate portion can be reinforced.

According to a further exemplary embodiment, the fillers in the second electrically insulating layer structure are partially in contact with the further electrically conductive structure. Hence, the fillers in an interface surface between the second electrically insulating layer structure and the further electrically conductive structure may increase the roughness and hence provide a stronger and more robust coupling between the second electrically insulating layer structure and the further electrically conductive structure, so that the risk of the delamination may be reduced.

According to a further exemplary embodiment, a portion of the further electrically conductive structure covers the lateral wall of the through hole. Specifically, the further electrically conductive structure covers the part of the lateral wall or the complete lateral wall of the through hole. Hence, a conductive path may be provided between the electrically conductive structure and the further electrically conductive structure. Thereby, an electrically conductive path between the first main surface at the second main surface of the first electrically conductive layer structure may be provided.

The lateral wall may be plated by the further electrically conductive structure, such as copper. Furthermore, the electrically conductive structure may also be selected to provide a thermal conductive function. Hence, the functional element inserted into the through hole and being in contact with the lateral sidewall may be used to guide thermal energy away from the first electrically insulating layer structure and component carrier, respectively. The further electrically conductive structure on the sidewalls of the through hole facilitates electrical connection of the component, in addition to the dissipation of heat.

According to a further exemplary embodiment, the thickness of the further electrically conductive structure on the first main surface of the first electrically insulating layer structure is greater than the thickness of the further electrically conductive structure on the lateral wall of the through hole. Hence, by providing a thicker edge portion of the further electrically conductive structure on the first main surface, the edges of the through holes at the first main surface can be properly protected by the robust edge portion.

According to a further exemplary embodiment, the lateral wall of the through hole is covered by a surface finish layer. The surface finish layer may be directly attached (coated) to the surface of the lateral wall. Furthermore, the surface finish may be applied on the surface of the further electrically conductive structure facing the inner volume of the through hole. The surface section of the further electrically conductive structure in the through hole is therefore more robust as this portion is exposed for the insertion of the functional element, such as an external electrode. The surface finish layer is required for protecting the internal side of the further electrically conductive structure in the through hole from corrosion due to possible insertion of the functional element for example of a component. In this way, the surface finish layer on the on the surface of the lateral wall of through hole improve the reliability of the connection of the electrical component in the through hole.

According to a further exemplary embodiment, the concentration of the fillers in the surrounding portion is higher when being closer to the fourth main surface. The higher concentration of the fillers in the surrounding portion closer to the fourth main surface may be provided due to a floating of the fillers during the curing and/or the lamination process. After the pressing during lamination, more fillers are concentrated close to the fourth surface, because due to the partially cured status of the second insulating layer, the resin is more viscous, and due to the pressure plate pressed against the second insulating layer during lamination (under application of heat), more of the resin may be squeezed toward the first electrically insulating layer structure and the through hole, respectively. Additionally, the concentration of fillers in the region of the fourth surface on the surrounding portion is higher than that on the cover portion and is lower than that of the intermediate portion.

Hence, the section closer to the fourth main surface is more reinforced and more robust due to the higher concentration of the fillers. Hence, better protection against impact onto the fourth main surface provided.

According to a further exemplary embodiment, the fillers in the second electrically insulating layer structure comprise fibers, in particular inorganic fibers, more in particular glass fibers. The presence of inorganic fibers, in particular glass fibers improves the reinforcement properties of the fillers.

According to a further exemplary embodiment, the fibers are woven. The woven fibers in the second electrically insulating layer structure defining a main direction, wherein the woven fibers define warps and wefts. The main direction of the woven fibers extends between an an upper plane and/or a lower plane defined by the vertical peaks of the warps and wefts. The main direction is defined as a direction along the length extension of the fibers. The main direction of the warps and the main direction of the wefts define a main plane. Furthermore, the main direction of the warps and the main direction of the wefts extend in the main plane substantially orthogonal with respect to each other. The upper plane and the lower plane are parallel to the main plane. The wrap and wefts fibers extend in the respective main direction in a kind of sinusoidal extension, wherein at the vertex point (i.e. the largest distance to the main plane), the vertical peaks of the respective wrap and wefts fibers are formed. The respective upper peaks form the upper plane and the respective lower peaks define the lower plane.

The upper and lower planes defined cover planes and may form at least a part of the fourth main surface and the third main surface of the second electrically insulating layer structure.

The warp fibers are more longitudinal (lengthwise) fibers and the weft fibers are the transverse (crosswise) fibers with respect to the warp fibers that are woven over and under the warp fibers. The weft fibers are inserted perpendicular to the warp with respect to the main plane, forming the fabric structure. Together, the interlacing of warp and weft fibers determines the strength, flexibility, and overall properties of the woven layer. The vertical peaks of the warps and wefts define the maximum distance of the fibers with respect to the main direction.

According to a further exemplary embodiment, the main direction of the woven fibers in the surrounding portion and/or the main direction of the woven fibers in the intermediate portion are parallel to a main surface (e.g. the first main surface) of the stack.

According to a further exemplary embodiment, the main direction of the woven fibers in the cover portion is not parallel to a main surface (e.g. the first main surface) of the stack. Hence, due to the flow of the material of the cover portion of the second electrical insulation layer structure into the through hole during lamination and hence due to the concentration of the fillers in the cover portion more to the through hole, the orientation of the fillers and hence of the woven fibers differs to the orientation of the woven fibers of the surrounding portion and/or the intermediate portion of the second electrically insulating layer structure.

According to a further exemplary embodiment, the woven fibers in the cover portion are deformed towards the through hole. Hence, more stiffness in multiple directions is given in the region of the cover layer.

According to a further exemplary embodiment, the woven fibers and/or the main direction of the woven fibers in the cover portion form a dimple, specifically in the fourth main surface. Hence, along the surface of the fourth main surface, the location of the covered through holes may be easier detectable, since the protrusion may be visualized.
According to a further exemplary embodiment of the method, the second electrically insulating layer structure is made of a curable material, wherein the stack is formed by attaching the second electrically insulating layer structure with the first electrically insulating layer structure. In an exemplary embodiment the cover portion has in particular a higher curing degree than the surrounding portion when the second electrically insulating layer structure is attached to the first electrically insulating layer structure. In a further exemplary embodiment, the second electrically insulating layer structure, in particular the cover portion of the second electrically insulating layer structure, has with a curing degree of 60-70% and/or with a viscosity of 4000 - 20000 Pa*s (Pascal second), in particular 7000-12000 Pa*s. The curing state refers to the degree to which the resin matrix of the second electrically insulating layer structure, in which the fillers are embedded, has reacted and advanced toward full polymerization. It is typically defined by the degree of cure (DoC), which quantifies how much of the resin has undergone chemical cross-linking. The degree of cure (DoC) is a measure of how much a thermosetting material (resin) in a composite material has polymerized (cross-linked) relative to its fully cured state. It is typically expressed as a percentage: $DoC = \left(Ho-Hr\right) / Ho \times 100 %$ Where:
Ho = Total heat of reaction (enthalpy) for a fully uncured resin.
Hr = Remaining heat of reaction (enthalpy) in the material at a given curing state. For example, a DoC defines the following material state:
   0-30% = the resin is mostly uncured; it remains tacky and flowable (B-stage).
   30-70% = Gelation occurs, where the resin transitions from a viscous liquid to a solid network.
   70-90% = Post-gelation curing continues; vitrification may occur if curing is at a low temperature.
   90-100% = The resin is fully cured, with optimized mechanical and thermal properties.

Hence, before a final lamination step, the second electrically insulating layer structure is not fully cured so that the second electrically insulating layer structure may comprise a lower viscosity and lower cross-linking state than the first electrically insulating layer structure. Prior to lamination between of the stack comprising the first and second electrically insulating layer structure and, a selective curing treatment may be performed on the second electrically insulating layer structure, leading to the formation of cover portion and surrounding portion with the cover portion having a higher degree of curing relative to the curing degree of the surrounding portion such that the cover portion of the second electrically insulating layer structure shows a lower flowability into the through hole.

Hence, as described below, in a final lamination step, the second electrically insulating layer structure may be fully cured and has a curing state of 100%, respectively.

In an example, the curing degree of the second electrically insulating layer structure, and in particular the curing degree of the cover portion with respect to the surrounding portion, is predetermined to allow a specific flow amount and/or a specific flow speed. An applied dielectric material may thus be tuned (for example by waiting for a specific time, using temperature curing (elevated temperatures), or hardening with UV light or IR light) in order to achieve the desired curing degree based on a curing degree criterion. In an example, curing may be done by a (any) electromagnetic radiation, e.g. with a wavelength 0.1 to 3000 nm, in particular 10 to 3000 nm, more in particular 800 to 2500 nm. Curing may be also done using a heat source, whereby a source of electromagnetic radiation may also be seen as a heat source in this context.

According to a further exemplary embodiment of the method, the stack is formed in lamination step by pressing the second electrically insulating layer structure to the first electrically insulating layer structure, in particular under application of heat. Specifically, a pressure plate may be pressed onto the fourth main surface for generating the necessary pressure force.

According to a further exemplary embodiment of the method, in the lamination step, the material of the cover portion of the second electrically insulating layer structure partially flows into the through hole. Specifically, in a final lamination step, the respective resin flow of the second electrically insulating layer structure and specifically of its cover portion into the through hole can be controlled by application of heat and pressure, for example applied by a lamination plate. After the final lamination step, the stack and the respective first and second electrically insulating layer structures are fully cured.

In an embodiment, the component carrier comprises a component, or a plurality of components. The one or more components may be surface mounted on the stack or embedded in the stack. In the context of the present application, the term "component" may particularly denote any bulky rather than layer-type block. The component may be an electronic component, such as an active (for example a semiconductor chip or semiconductor package) or passive (for instance a capacitor or an inductor) electronic component embedded or to be embedded within an interior of the component carrier. However, the component may also be a non-electronic component without electronic functionality. For example, the component may be a component with thermal functionality, such as a heat removal and/or heat spreading functionality. For example, the component may be a metal (for instance copper) block and/or ceramic block.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through hole connections. The filled hole either connects the whole stack, (through hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures (i.e. fillers) such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These pre-pregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier obtained from the component carrier structure is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

The aspects defined above and further aspects of the invention are apparent from the examples of embodiment to be described hereinafter and are explained with reference to these examples of embodiment.
Figure 1 illustrates a schematic view of a component carrier according to an exemplary embodiment of the invention.
Figure 2 illustrates a schematic image of a component carrier similar to the schematic view shown in Figure 1 according to an exemplary embodiment of the invention.
Figure 3 illustrates a schematic image of a component carrier comprising a further electrically conductive structure according to an exemplary embodiment of the invention.
Figure 4 illustrates a schematic view of a component carrier having protrusions in a fourth main surface of a second electrically insulating layer structure according to an exemplary embodiment of the invention.
Figure 5 illustrates a schematic view of woven fibers in the second electrically insulating layer structure according to an exemplary embodiment of the invention.
Figure 6 to 10 illustrates a manufacturing method of a component carrier according to an exemplary embodiment of the present invention.

The illustrations in the drawings are schematic. In different drawings, similar or identical elements are provided with the same reference signs.

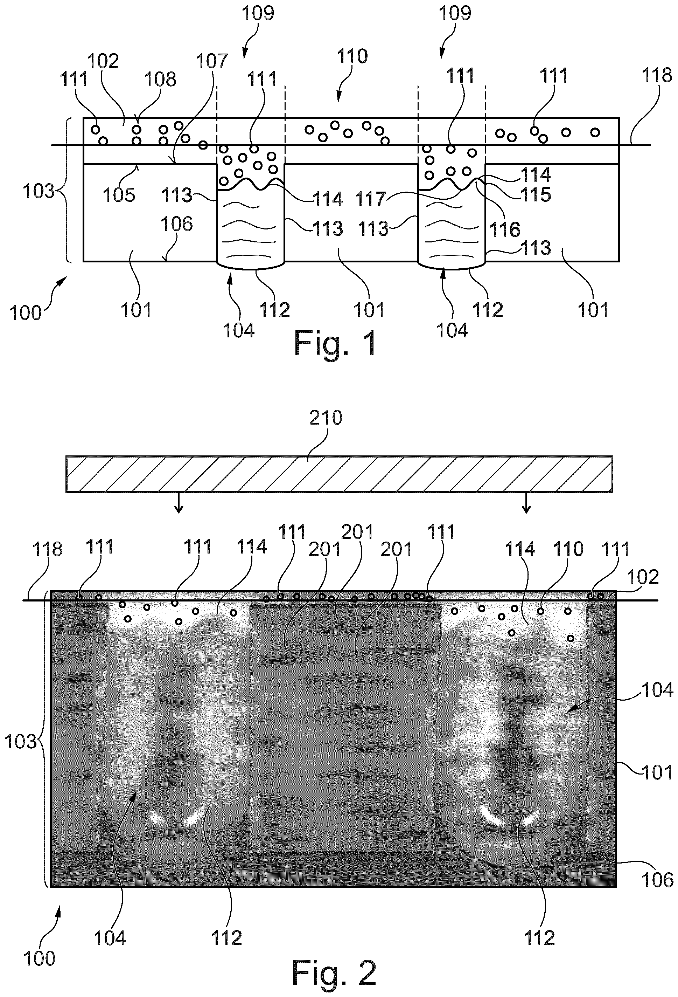

**Figure 1** shows a component carrier 100 comprising a stack 103 with a plurality of electrically insulating layer structures 101, 102. **Figure 2** shows a respective image of the embodiment shown in Figure 1.

A first one 101 of the plurality of electrically insulating layer structures comprising a through hole 104 passing from a first main surface 105 to an opposed second main surface 106 of the first electrically insulating layer structure 101. A second one 102 of the plurality of electrically insulating layer structures comprises fillers 111 embedded therein, wherein the second electrically insulating layer structure 102 comprises a third main surface 107 in contact with the first main surface 105 of the first electrically insulating layer structure 101, closing the through hole 104, and comprises a fourth main surface 108 opposed to the third main surface 107. The second electrically insulating layer structure 102 comprises a cover portion 109 and a surrounding portion 110, wherein the cover portion 109 overlaps the through hole 104. The fillers 111 in the surrounding portion 110 are closer to the fourth main surface 108 than the fillers 111 in the cover portion 109.
The component carrier 100 is configured as a support structure which is capable of accommodating one or more components thereon and/or therein for providing mechanical support and/or electrical connectivity. In other words, a component carrier 100 may be configured as a mechanical and/or electronic carrier for components. The stack 103 comprises the first and second electrically insulating layer structures 101, 102 which are mounted in parallel on top of one another. For example, the stack 103 may be a laminated stack, i.e. comprising a plurality of layer structures 101, 102 connected by the application of heat and/or pressure.

The first electrically insulating layer structure 101 consists of one or a plurality of layers and comprises for example resin without fibers or comprising for example further fillers, such as fibers, which are woven or which comprises a uniform direction. Preferably, the first electrically insulating layer structure 101 and/or the second electrically insulating layer structure 102 may comprise organic polymeric material, for example epoxy resin and/or poly (meth)acrylate.

The first electrically insulating layer structure 101 comprises respective through holes 104 between first main surface 105 and the opposed second main surface 106 of the first electrically insulating layer structure 101.

The first main surface 105 of the first electrically insulating layer structure defines the surface, onto which the second electrically insulating layer 102 directly abuts and fixed, e.g. by curing. The second main surface 106 of the first electrically insulating layer structure 101 defines the main surface being opposed to the first main surface 105. The respective through hole 104 extends between the first main surface 105 and the second main surface 106 through the first electrically insulating layer structure 101.

The third main surface 107 of the second electrically insulating layer structure defines the surface, which directly abuts onto and is fixed to the first main surface 105. The fourth main surface 108 of the second electrically insulating layer structure is the main surface opposed to the third main surface 107 and faces away from the first electrically insulating layer structure 101.

The through holes 104 extend through the stack 103 and in particular through the first electrically insulating layer structure 101 substantially perpendicular to first main surfaces 105 of the first insulating layer structure 101. The through holes 104 may be formed for instance by laser drilling with appropriate laser operation parameters in such a way that lateral walls 113 of the first electrically insulating layer structure 101 define the through holes 104. Additionally or alternatively, the through holes 104 may be formed by a mechanical drilling process.

The second electrically insulating layer structure 102 may be made of resin comprising the fillers 111. The fillers 111 provide a reinforcing function of the second electrically insulating layer structure 102.

The second electrically insulating layer structure 102 comprises the cover portion 109 and the surrounding portion 110. The cover portion defines in a plane on the first main surface 105 having a normal and a view direction, respectively, perpendicular to the first main surface 105 the portion that covers the opening of the through hole 104 at the first main surface 105. The surrounding portion 110 surrounds the respective cover portion 109 and edge sections of the through hole 104 at the first main surface 105.

As can be seen in Figure 1 and Figure 2, the fillers 111 of the surrounding portion 110 are closer to the fourth main surface 108 and the fillers 111 of the cover portion 109 are closer to the first main surface 105 of the first electrically insulating layer structure 101 and optionally partially in the through hole 104. Hence, the fillers 111 of the cover portion 109 are specifically concentrated in the region of the through hole 104, so that due to the higher concentration fillers 111, a higher viscosity is achieved and the cover portion 109 is harder in the lower region close to or in the through hole 104 so that the flow of the material resin of the cover portion 109 into the through hole 104 is reduced and more controllable.

For example, when separating the cover portion 109 and the surrounding portion 110 of the second electrically insulating layer structure 102 by a central dividing plane 118 being parallel to the first main surface 105 in a first (lower) volume part of the second electrically insulating layer structure 102 being closer to the third main surface 107 and a second volume part of the second (upper) electrically insulating layer structure 102 being closer to the fourth main surface 108, in the first volume part of the cover portion 109, the concentration of fillers 111 is higher than the concentration of fillers 111 in the second volume part. Accordingly, in the surrounding portion 110, in the first volume part, the concentration of fillers 111 is lower than the concentration of fillers in the second volume part.

Specifically, the respective control of the resin flow in direction to the through hole 104 and specifically inside the through hole 104 can be achieved by providing the second electrically insulating layer structure 102, comprising a first curing state for example with a higher viscosity, higher cross-linking state, more hardened, etc. in the cover portion 109 and a second curing state in the surrounding portion 110.

The through holes 104 and specifically the lateral walls 113 are filled and/or plated with the electrically conductive structure 112 or, as shown in Fig. 1, are filled with a solid material of the electrically conductive structure 112 that fills partially the inner volume of the through hole 104. In an example, the solid material filling the through hole 104 may comprise electrically conductive material, in particular the electrically conductive layer structure 112. Preferably, the solid material may comprise metal, in particular copper. The solid material may cover the lateral walls of the through hole 104. The electrically conductive structure 112 may be plated to lateral walls 113 of the through hole 104 before attaching the second electrically insulating layer structure 102 on top of the first main surface 105 of the first electrically insulating layer structure 101. However, in an alternative manufacturing step, the second electrically insulating layer structure 102 may be fixed by lamination to the first main surface 105 of the first electrically insulating layer structure 101 and specifically after a lamination step i.e. after applying heat and pressure to the respective stack 103, the through holes 104 are filled with solid material of the respective electrically conductive structure 112.

The material of the cover portion 109 of the second electrically insulating layer structure 102 partially fills the through hole 104. The cover portion 109 flows from the first main surface 105 into the through hole 104. By defining more exact the amount of the cover portion 109 flowing during lamination into the through hole 104 and by the higher concentration of fillers 111 in the cover portion 109 close to the first main surface 105 and for example partially within the through hole 104, respectively, the insertion depth of a functional element or of the electrically conductive structure 112 in the through hole 104, for example inserted from the second main surface into the through hole 103, may be exactly defined.

As can be seen in Figure 1 and Figure 2, the material of the cover portion 109 in the through hole 104 defines an internal boundary line 114 between the electrically conductive structure 112 and the material of the cover portion 109. Specifically, if the electrically conductive structure 112 is a solid material that fills the inner volume along the complete cross-section of the through hole 104, the internal boundary line 114 defines the interface plane between the interface of the electrically conductive structure 112 within the through hole 104 and the cover portion 109. The internal boundary line 114 has an irregular shape.

The material of the cover portion protrudes at the lateral walls 113 of the through hole 104 deeper in the through hole 104 to form a side portion 115 that protrudes more into the through hole 104 than a central portion 116 of the cover portion 109 protruding in a central section in the through hole 104. Hence, when viewing from the second main surface 106 to the first main surface 105 in the through hole 104, the center section forms a dimple. At the central portion 116 of the cover portion 109, a central protrusion 117 of material of the cover portion 109 protrudes in a direction from the first main surface 105 into the through hole 104 more than other portions surrounding the protrusion of the central portion 116. The material of the cover portion 109 of the second electrically insulating layer structure 102 is penetrating in the through hole 104 with a depth less than four times the thickness of the second electrically insulating layer structure 102. The main part of the through hole 104 is filled with the electrically conductive structure 112 and the material of the cover portion 109 within the through hole 104 forms a kind of seat for the electrically conductive structure 112 within the through hole 104.

The first electrically insulating layer structure 101 comprises further fillers 201, for example fibers in a woven state. The first electrically insulating layer structure 101 comprises a plurality of fiber layers each respective fiber layer being arranged one above another along the stacking direction and interwoven with each other. The further fillers form a roughened lateral wall 113 of the through hole 104. Hence, when cutting the through holes 104, in particular by laser drilling or by mechanical drilling, cut fiber residues are formed along lateral walls 113 of the through hole 104. Hence, by cut fibers, respectively, the roughened lateral wall 113 of the through hole 104 is formed. Thus, a stronger engagement and bonding between the lateral walls 113 and the cover portion 109 can be provided.

The second electrically insulating layer structure 102 is made of a curable material, wherein the stack 103 is formed by attaching the second electrically insulating layer structure 102 with the first electrically insulating layer structure 101.

Before a final lamination step, the second electrically insulating layer structure 102 may be uncured or semi-cured, so that the second electrically insulating layer structure 102 may comprise a lower viscosity and lower cross-linking state than the first electrically insulating layer structure 101. Specifically a partially curing step may be applied with a mask doing IR radiation to create the cover portions and the surrounding portion, in particular with different curing degrees between each other. Thereby, in particular the curing degree of the cover potion is increased but still not fully cured.
Next, in the final lamination step, a lamination plate 210 is pressed onto the fourth main surface 108 of the second electrically insulating layer structure 102 for pressing the second electrically insulating layer structure 102 to the first electrically insulating layer structure 101, in particular under application of heat. The lamination process mechanically connects the first to the second electrically insulating layer structures 101, 102 and prevents the though hole to be fully filled (due to the pre curing of specifically the cover portion) and finally the second electrically insulating layer structure is fully cured. The lamination can be split into two process steps as described here, or can be done within one procedure. Finally, the stack may be fully cured with a curing degree of 100%.

Specifically, in the lamination step, the respective resin flow of the second electrically insulating layer structure 102 and specifically of its cover portion 109 into the through hole 104 can be controlled by application of heat and pressure, for example applied by a lamination plate 210.

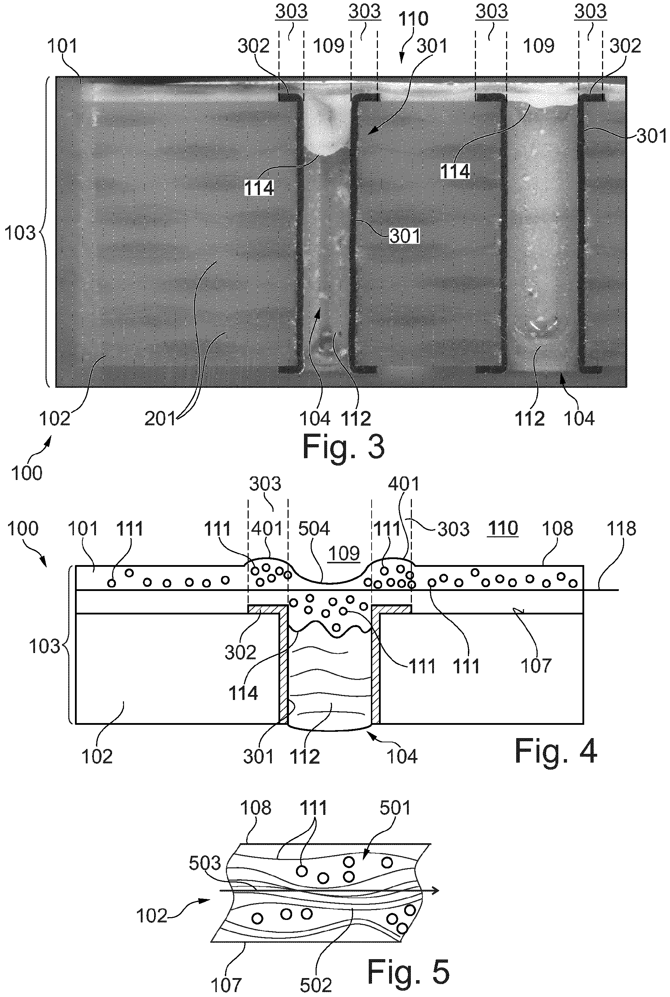

**Figure 3** illustrates a schematic image of a component carrier 100 comprising further electrically conductive structures 301 according to an exemplary embodiment of the invention.

The at least one further electrically conductive structure 301 comprises an edge portion 302 provided around the through hole 104 on the first main surface 105 and is sandwiched between the first electrically insulating layer structure 101 and the second electrically insulating layer structure 102. The further electrically conductive structure 301 covers the first main surface 105 around the through hole 104. The further electrically conductive structure 301 further comprises an internal section that extends within the through hole 104 and covers the lateral wall 113 of the through hole 104. The edge portion 302 forms a conductive bridge between the first main surface 105 and the above-mentioned electrically conductive structure 112 filled within the through hole 104. Since the edge portion 302 of the further electrically conductive structure 301 is attached onto the first main surface 105, a step along the first main surface 105 is formed so that the flow characteristics of the second electrically insulating layer structure 102 during lamination can be affected.

The second electrically insulating layer structure 102 comprises an intermediate portion 303 arranged between the cover portion 109 and the surrounding portion 110. The intermediate portion 303 overlaps the edge portion 302, wherein the fillers 111 of the second electrically insulating layer structure 102 in the intermediate portion 303 are closer to the fourth main surface 108 than the fillers 111 in the cover and/or the surrounding portion 110. Hence, in the intermediate portion 303, the edge portion 302 is arranged between the first main surface 105 of the first electrically insulating layer structure 101 and the second electrically insulating layer structure 102. Furthermore, the intermediate portion 303 is arranged between the cover portion 109 and the surrounding portion 110. Hence, as described above, the edge portion 302 forms a step onto the first main surface 105 and thereby affects the flowing characteristics of the second electrically insulating layer structure 102 for example during lamination. Hence, due to the edge portion 302 forming a step onto the first main surface 105 affecting the flow characteristics of the of the second electrically insulating layer structure 102, thereby, as can be seen more clearly in Figure 4, the fillers 111 in the intermediate portion 303 are closer to the fourth main surface 108 than the fillers 111 in the cover and/or the surrounding portion 110. As a result, in the intermediate portion 303, the part of the second electrically insulating layer structure 102 being closer to the fourth main surface 108 is more robust than the part of the second electrically insulating layer structure 102 being closer to the fourth main surface 108 in the surrounding portion 110 and/or the cover portion 109.

Specifically, in Figure 3 two through holes 104 are shown, wherein one through hole 104 (left one in Fig. 3) comprises more resin penetration from the cover portion 109 of the second electrically insulating layer structure 102 while the other through hole 104 (right one in Fig. 3) comprises less resin penetration from the cover portion 109 of the second electrically insulating layer structure 102. Hence, the boundary line 114 of one (left) through hole 104 is arranged deeper in the through hole than the other boundary line 114 of the other (right) through hole 104. This may be due to the different degree of curing of the two cover portions 109. For example, referring to Figure 3, the degree of curing of the left cover portion 109 covering the left through hole 104 may be lower (thus, the viscosity of the left cover portion 109 is lower) than the degree of curing of the right cover portion 109 covering the right through hole 104 (thus, the viscosity of the right cover portion 109 is higher).

**Figure 4** illustrates a schematic view of a component carrier 100 having protrusions 401 in a fourth main surface 108 of the second electrically insulating layer structure 102 according to an exemplary embodiment of the invention. The embodiment shown in Figure 4 is similar to the one shown in Figure 3. In the embodiment shown in Figure 4 it is further outlined that the second electrically insulating layer structure 102 is formed such that the fourth main surface 108 comprises the protrusion 401, in particular a bump, at the intermediate portion 303. Hence, since the edge portion 302 of the further electrically conductive structure 301 is arranged in the intermediate section 303 between the second electrically insulating layer structure 102 and the first electrically insulating layer structure 101, the protrusion 301 may be formed at the intermediate portion 303.

Furthermore, the fillers 111 in the second electrically insulating layer structure 102 are embedded in a matrix material, in particular resin, wherein the ratio of fillers 111/matrix material in the intermediate portion 303 is higher than the ratio of fillers 111/matrix material in the cover portion 109 and the surrounding portion 110. Hence, since the edge portion 302 forms a step onto the first main surface 105 and thereby affects the flowing characteristics of the second electrically insulating layer structure 102 for example during lamination, as a result, the overall ratio and hence concentration of the fillers 111 in the matrix material is increased.

The fillers 111 in the second electrically insulating layer structure 102 are partially in contact with the further electrically conductive structure 301. Hence, the fillers 111 in an interface surface between the second electrically insulating layer structure 102 and the further electrically conductive structure 301 may increase the roughness and hence provide a stronger and more robust coupling between the second electrically insulating layer structure 102 and the further electrically conductive structure 301.

A portion of the further electrically conductive structure 301 covers the lateral wall 113 of the through hole 104. Specifically, the further electrically conductive structure 301 covers the lateral wall 113 of the through hole 104. Hence, a conductive path may be provided between the electrically conductive structure 112 and the further electrically conductive structure 301. Thereby, an electrically conductive path between the first main surface 105 at the second main surface 106 of the first electrically conductive layer structure is provided.

The thickness of the edge portion 302 of the further electrically conductive structure 301 on the first main surface 105 of the first electrically insulating layer structure 101 is greater than the thickness of the further electrically conductive structure 301 on the lateral wall 113 of the through hole 104. The lateral wall 113 of the through hole 104 may also be covered by a surface finish layer. The surface finish layer may be directly attached coated to the surface of the lateral wall 113. Furthermore, the surface finish may be applied on the surface of the further electrically conductive structure 301 facing the inner volume of the through hole 104.

As highlighted by the dividing plane 118, in a region close to the fourth main surface 108, the concentration of the fillers 111 in the intermediate portion 303 is in the protrusion 401 higher than in the surrounding portion 110. Furthermore, the concentration of the fillers 111 in a region close to the fourth main surface 108 is lower in the cover portion 109. The higher concentration of the fillers 111 closer to the fourth main surface 108 may be provided due to a floating of the fillers 111 during the curing and/or the lamination process.

**Figure 5** illustrates a schematic view of woven fibers in the second electrically insulating layer structure 102 according to an exemplary embodiment of the invention. The woven fibers 111 in the second electrically insulating layer structure 102 define a main direction 503, wherein the woven fibers define warps 501 and wefts 502. The main direction 503 is defined as a direction along the length extension of the fibers 111. The main direction 503 of the warps 501 and the main direction 503 of the wefts 502 define a main plane. Furthermore, the main direction 503 of the warps 501 and the main direction 503 of the wefts 502 extend in the main plane substantially orthogonal with respect to each other. The upper plane and the lower plane are parallel to the main plane. The wrap and wefts fibers 501, 502 extend in the respective main direction in a kind of sinusoidal extension, wherein at the vertex point (i.e. the largest distance to the main plane), the vertical peaks of the respective wrap and wefts fibers are formed. The respective upper peaks form the upper plane and the respective lower peaks define the lower plane.

The weft fibers 502 are the transverse crosswise fibers with respect to the warp fibers 501 that are woven over and under the warp fibers 501. The weft fibers 502 are inserted perpendicular to the warp 501 with respect to a weaving direction, creating the fabric structure. The main direction 503 of the woven fibers in the surrounding portion 110 and/or the main direction 503 of the woven fibers in the intermediate portion 303 are parallel to e.g. the first main surface 105.

The main direction 503 of the woven fibers in the cover portion 109 is not parallel to a main surface of the stack 103 and e.g. the first main surface 105, respectively. Hence, due to the flow of the material of the cover portion 109 of the second electrically insulation layer structure 102 into the through hole 104 during lamination and hence due to the concentration of the fillers 111 in the cover portion 109 more to the through hole 104, the orientation of the fillers 111 and hence of the woven fibers differs to the orientation of the woven fibers of the surrounding portion 110 and/or the intermediate portion of the second electrically insulating layer structure 102. Therefore, the woven fibers in the cover portion 109 are deformed towards the through hole 104.

Along the surface of the fourth main surface 108, the second electrically insulating layer structure 102 forms in the cover portion 109 a dimple 504 in the fourth main surface 108. Hence, by the formed dimple 504, the location of the covered through holes 104 below the cover portion 109 may be easier detectable.

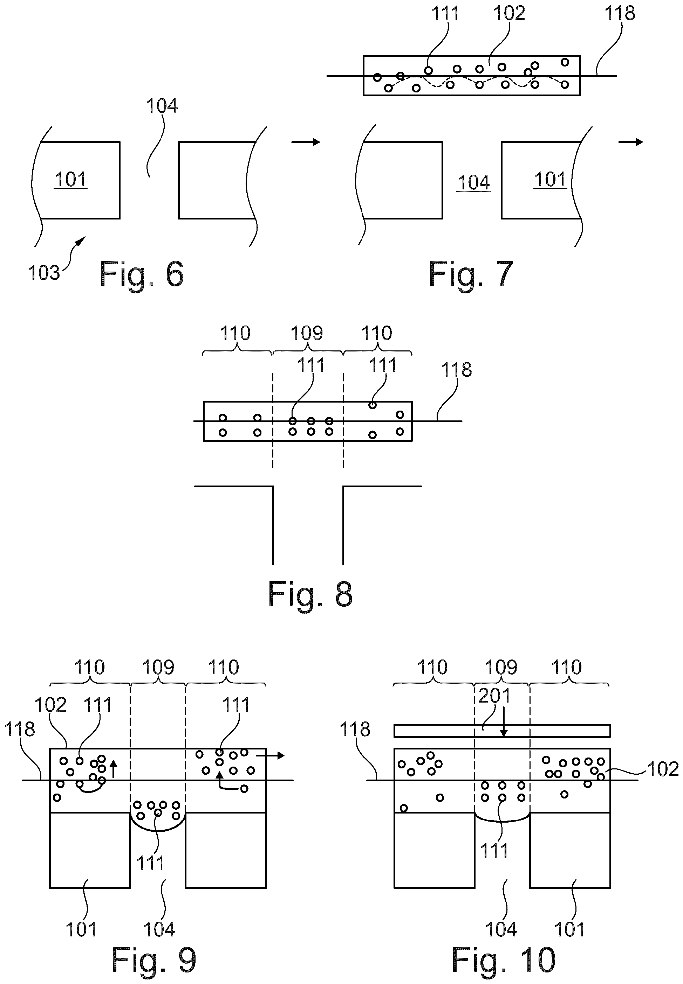

Figures 6 to 10 show an exemplary manufacturing method of a component carrier 100 according to the present invention.

First, as shown in **Figure 6****,** stack 103 with at least a first electrically insulating layer structure 101 is provided. The respective through holes 104 are formed for example by drilling.

Next, as shown in **Figure 7****,** the second electrically insulating layer structure 102 comprising the fillers 111 is provided. In this initial stage, the concentration of the fillers 111 may be homogeneous throughout the complete second electrically insulating layer structure 102.

As shown in **Figure 8****,** before being attached to the first electrically insulating layer structure 101, the second electrically insulating layer structure 102 is partially cured specifically at the cover portion 109. The spatial deviation of the concentration of the fillers 111 in the surrounding portion 110 and the concentration of the fillers 111 in the cover portion 109 may be attributed to the reason that prior to lamination, a selective curing treatment is performed on the second electrically insulating layer structure 102, leading to the formation of cover portion 109 and surrounding portion 110 with the cover portion 109 having a higher degree of curing relative to the curing degree of the surrounding portion 110 such that the second electrically insulating layer structure shows 102 a lower flowability into the through hole 104 in subsequent manufacturing steps.

In a next step, as shown in **Figure 9****,** the second electrically insulating layer structure 102 is attached onto the first electrically insulating layer structure 101, so that the cover portion 109 covers the through holes 104. Due to the application of pressure, the cover portion 109 may be at least partially transferred into the through hole 104, which is covered by the cover portion 109.

Finally, as can be seen in **Figure 10****,** in a lamination step the pressure plate 201 presses the second electrically insulating layer 102 onto the first electrically insulating layer structure 101 so that both electrically insulating layer structures 101, 100 to are fixed together. Specifically, to achieve a reliable adhesion between the first electrically insulating layer structure 101 and the second of the plurality of electrically insulating layer structure 102, the first electrically insulating layer structure 101 having the through hole 104 and the second electrically insulating layer structure 102 comprising the fillers may be laminated together by application of elevated pressure, for example larger than 1.5 bar, with the pressure plate 201. Due to the application of pressure during lamination, there is movement of the resin and the fillers 111 of the second electrically insulating layer structure 102 (for example resulting in squeezing out of resin from the surrounding portion 110) thereby finally resulting in the accumulation of fillers of the surrounding portion 110 closer to the fourth main surface 108. The aforementioned action may happen simultaneously during the lamination process with the result of the lamination process, that the cover portion 109 overlapping the through hole 104 may have fillers farther away from the fourth main surface 108 than the fillers 111 of the surrounding portion 110.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

List of reference signs:
100 component carrier
101 first electrically insulating layer structure
102 second electrically insulating layer structure
103 stack
104 through hole
105 first main surface
106 second main surface
107 third main surface
108 fourth main surface
109 cover portion
110 surrounding portion
111 filler
112 electrically conductive structure
113 lateral wall
114 boundary line
115 side portion
116 central portion
117 central protrusion
118 dividing plane
201 further fillers
210 lamination plate
301 further electrically conductive structure
302 edge portion
303 intermediate portion
401 protrusion
501 warp
502 weft
503 main direction
504 dimple

## Claims

1. Component carrier (100), comprising
a stack (103) comprising a plurality of electrically insulating layer structures,
wherein a first one (101) of the plurality of electrically insulating layer structures comprising a through hole (104) passing from a first main surface (105) to an opposed second main surface (106) of the first electrically insulating layer structure (101),
wherein a second one (102) of the plurality of electrically insulating layer structures comprises fillers (111) embedded therein,
wherein the second electrically insulating layer structure (102) comprises a third main surface (107) in contact with the first main surface (105) of the first electrically insulating layer structure (101), closing the through hole (104), and comprises a fourth main surface (108) opposed to the third main surface (107),
wherein the second electrically insulating layer structure (102) comprises a cover portion (109) and a surrounding portion (110), wherein the cover portion (109) overlaps the through hole (104),
wherein the fillers (111) in the surrounding portion (110) are closer to the fourth main surface (108) than the fillers (111) in the cover portion (109).

2. Component carrier (100) according to claim 1,
wherein the through hole (104) is configured to be penetrated by a functional element.

3. Component carrier (100) according to claim 1 or 2,
wherein a lateral wall of the through hole (104) is covered by an electrically conductive structure.

4. Component carrier (100) according to one of the claims 1 to 3,
wherein the material of the cover portion (109) of the second electrically insulating layer structure (102) partially fills the through hole (104).

5. Component carrier (100) according to claim 3 and 4,
wherein the material of the cover portion (109) in the through hole (104) defines an internal boundary line (114) between the electrically conductive structure and the material of the cover portion (109)
wherein the internal boundary line (114) has in particular an irregular shape.

6. Component carrier (100) according claim 4 or 5,
wherein the material of the cover portion (109) protrudes at the lateral walls of the through hole (104) and/or the respective electrical conductive structure to form a side portion (115) that protrudes more into the through hole (104) than a central portion (116) of the cover portion (109) protruding in a central section of the through hole (104)
wherein in particular at the central portion (116) of the cover portion (109), a central protrusion (117) of material of the cover portion (109) is formed, protruding more than other portions of the central portion.

7. Component carrier (100) according to one of the claims 1 to 6,
wherein material of the cover portion (109) of the second electrically insulating layer structure (102) is penetrating in the through hole (104) with a depth less than four times the thickness of the second electrically insulating layer structure (102).

8. Component carrier (100) according to one of the claims 1 to 7,
wherein the first electrically insulating layer structure (101) comprises further fillers (201),
wherein the further fillers (201) form a roughened lateral wall of the through hole (104),
wherein the material of the cover portion (109) of the second electrically insulating layer structure (102) is coupled to the roughened lateral wall of the through hole (104).

9. Component carrier (100) according to one of the claims 1 to 8,
wherein the stack (103) comprises at least one further electrically conductive structure (301),
wherein the at least one further electrically conductive structure (301) comprises an edge portion (302) provided around the through hole (104) on the first main surface (105) and sandwiched between the first electrically insulating layer structure (101) and the second electrically insulating layer structure (102)
wherein the second electrically insulating layer structure (102) comprises in particular an intermediate portion (303) arranged between the cover portion (109) and the surrounding portion (110),
wherein the intermediate portion (303) in particular overlaps the edge portion (302),
wherein in particular the fillers (111) in the intermediate portion (303) are closer to the fourth main surface (108) than the fillers (111) in the cover and/or the surrounding portion (109, 110).

10. Component carrier (100) according to one of the claims 1 to 9,
wherein the concentration of the fillers (111) in the surrounding portion (110) of the second electrically insulating layer structure (102) is higher when being closer to the fourth main surface (108).

11. Component carrier (100) according to one of the claims 1 to 10, wherein the fillers (111) comprise fibers, in particular inorganic fibers, more in particular glass fibers,
wherein the fibers are in particular woven,
wherein in particular the woven fibers defining a main direction, and the woven fibers define warps (501) and wefts (502),
wherein in particular along the main direction the woven fibers extends between an upper plane and/or a lower plane defined by the vertical peaks of the warps (501) and wefts (502).

12. Component carrier (100) according to claim 9 and 11,
wherein the main direction of the woven fibers in the surrounding portion (110) and/or the main direction of the woven fibers in the intermediate portion (303) are parallel to a main surface of the stack,
wherein in particular the main direction of the woven fibers in the cover portion (109) is not parallel to a main surface of the stack, wherein in particular the woven fibers in the cover portion (109) are deformed towards the through hole (104).

13. Component carrier (100) according to claim 9 or 12,
wherein the woven fibers and/or the main direction of the woven fibers in the cover portion (109) form a dimple.

14. Method of manufacturing a component carrier (100), the method comprising
forming a stack (103) comprising a plurality of electrically insulating layer structures,
forming a through hole (104) in a first one of the plurality of electrically insulating layer structures, the through hole (104) passing from a first main surface (105) to a second opposed main surface of the first layer electrically insulating layer structure,
wherein a second one of the plurality of electrically insulating layer structures comprises fillers (111) embedded therein,
wherein the second electrically insulating layer structure (102) comprises a third main surface (107) in contact with the first main surface (105) of the first electrically insulating layer structure (101), closing the through hole (104), and comprises a fourth main surface (108) opposed to the third main surface (107),
wherein the second electrically insulating layer structure (102) comprises a cover portion (109) and a surrounding portion (110), wherein the cover portion (109) overlaps the through hole (104),
wherein the fillers (111) in the surrounding portion (110) are closer to the fourth main surface (108) than the fillers (111) in the cover portion (109).

15. Method according to claim 14,
wherein the second electrically insulating layer structure (102) is made of a curable material,
wherein the stack (103) is formed by attaching the second electrically insulating layer structure (102) with the first electrically insulating layer structure (101),
wherein the cover portion (109) has in particular a higher curing degree than the surrounding portion (110) when the second electrically insulating layer structure (102) is attached to the first electrically insulating layer structure (101),
wherein the second electrically insulating layer structure (102), in particular the cover portion (109) of the second electrically insulating layer structure (102), has a curing degree of 60-70% and/or with a viscosity of 4000 - 20000 Pa*s, in particular 7000-12000 Pa*s.
